# EUROPEAN PATENT SPECIFICATION

(11) **EP 0 481 094 B1**
(45) Date of publication and mention of the grant of the patent: **09.08.2000**
(21) Application number: 91908786.6
(22) Date of filing: 07.05.1991
(51) Int. Cl.: H01L 31/045, H01L 31/05, H01L 31/0392, H01L 27/142

(54) **SOLAR CELL**
SOLARZELLE
CELLULE SOLAIRE

(30) Priority: 07.05.1990 JP 11582590
(43) Date of publication of application: 22.04.1992
(73) Proprietor: CANON KABUSHIKI KAISHA, Ohta-ku Tokyo 146-8501 (JP)
(72) Inventor: KAWAKAMI, Soichiro, c/o Canon Kabushiki Kaisha, Tokyo 146 (JP)
(74) Representative: Bühling, Gerhard, Dipl.-Chem.
(86) International application number: PCT/JP91/00603
(87) International publication number: WO 91/17572

(56) References cited:
- EP-A- 0 078 541
- EP-A- 0 103 168
- JP-A- 2 001 992
- JP-A- 58 103 178
- JP-A- 58 176 977
- JP-A- 63 287 076
- PATENT ABSTRACTS OF JAPAN vol. 9, no. 274 (E-354)(1997) 31 October 1985 & JP-A-60 117 684 (HITACHI SEISAKUSHO K.K.) 25 June 1985

## Description

The present invention relates to a solar cell comprising a plurality of photovoltaic elements being integrated on a conductive substrate.

In recent years, heating of the earth because of the so-called greenhouse effect due to an increase of atmospheric CO₂ has been predicted. Thus, there is an increased demand for a means of power generation capable of providing clean energy without causing CO₂ buildup. Now, nuclear power generation has been considered to be advantageous in view of not causing CO₂ buildup. However, as for nuclear power generation, possible problems concerning leakage of injurious radioactive materials from the nuclear power generation system, treatment of radioactive wastes, and the like have not completely eliminated yet. Thus, nuclear power generation cannot be a sufficiently safe power source of supplying clean energy. In this respect, the public attention has been recently focused on power generation by a solar cell as it is safe and supplies clean energy without those problems as above mentioned. As for solar cells, there are expectations since they are safe and easy to be handled.

Now, as for solar cells, a number of proposals have already been made. Among those proposed solar cells, amorphous silicon or copper indium selenide solar cells have been spotlighted and various studies have been made thereon since they can be easily 'designed to be of a large area and they can be provided at a relatively reduced production cost.

In general, it is required for solar cells to excel in weather resistance, shock resistance, and flexibility. In order to meet these requirements, a metal (conductive) substrate is often used as their substrate.

In order to obtain a desired electromotive force from a solar cell, it is generally performed to provide a plurality of photovoltaic elements respectively comprising a photovoltaic layer disposed on a conductive substrate made of stainless steel, etc. and connect those photovoltaic elements by means of wiring.

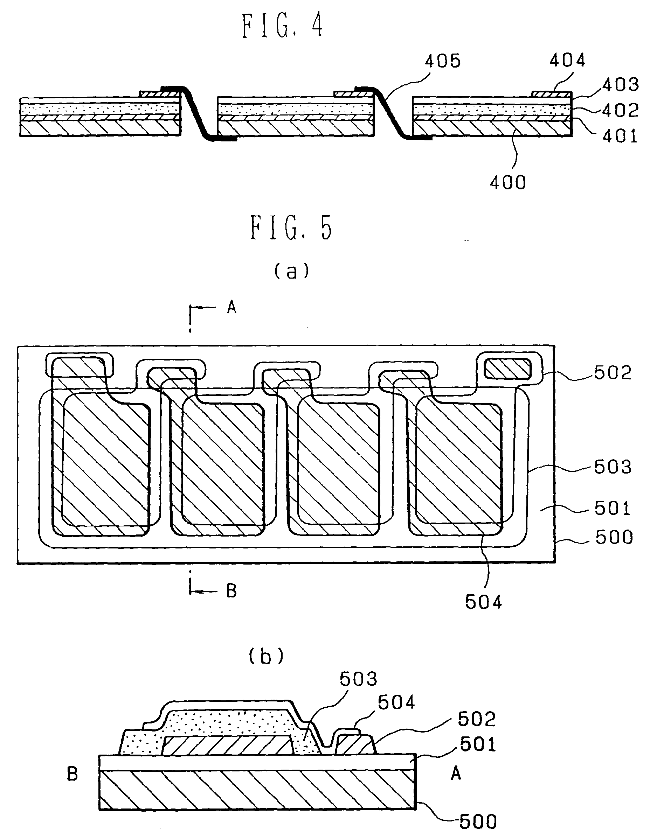

FIG. 4 is a schematic diagram of a known solar cell module comprising a plurality of photovoltaic elements serially wired with each other by means of wiring materials. In FIG. 4, reference numeral 400 is a conductive substrate, reference numeral 401 is a lower electrode, reference numeral 402 is a semiconductor layer (photovoltaic layer), reference numeral 403 is an upper electrode, reference numeral 404 is a collecting electrode, and reference numeral 405 is a wiring material to electrically connect adjacent photovoltaic elements.

Japanese patent publications JP-A-55 107 276 and JP-A-58 048 973 propose a method of integrating a plurality of solar cell elements on a common insulating substrate by means of masking evaporation or the like. As a modification of said method, there is known a method in which an insulating layer is applied onto the surface of a conductive substrate, metal electrode patterns are successively formed by means of masking evaporation or the like, the metal electrode is connected to the transparent electrode with respect to adjacent photovoltaic elements (subcells) disposed on the same substrate. FIG. 5 is a schematic diagram of a known solar cell module comprising a plurality of photovoltaic elements integrated on a common substrate by means of masking evaporation.
FIG. 5(a) is a plan view of said solar cell module, and FIG. 5(b) is a schematic cross-section view taken along the line A - B of the solar cell module shown in FIG. 5(a). In FIG. 5, reference numeral 500 is a conductive substrate, reference numeral 501 is an insulating layer, reference numeral 502 is a lower electrode, reference numeral 503 is a semiconductor layer (photovoltaic layer), and reference numeral 504 is a transparent electrode as an upper electrode.

As for the method of connecting a plurality of photovoltaic elements by means of the serial wiring, there are problems that it takes time in the connecting step and a product obtained becomes unavoidably costly.

Likewise, as for the method of serially connecting a plurality of photovoltaic elements on an identical substrate by means of the masking evaporation, there are problems that it is difficult to precisely align masks and it is extremely difficult to attain a high yield particularly in the case of producing a large area module; in addition to this, a variety of masks are required to be used in order to comply with a desired power capacity or/and a desired shape; and as a result, a product obtained becomes unavoidably costly.

As above described, there is known a solar cell module formed by integrating a plurality of photovoltaic elements respectively disposed on an insulating substrate. There has been proposed a method of performing integration of the photovoltaic elements in this case by using laser beam.

However, in the case where the laser beam processing is employed in order to integrate a plurality of photovoltaic elements respectively provided with a conductive substrate such as a metal, laser beam is irradiated to the conductive electrode (for example, metal electrode) formed on the insulating layer disposed on the conductive substrate to thereby pattern said conductive electrode. In this case, portions of the conductive substrate which are situated under portions of the metal electrode to be removed through patterning are often fused to cause short-circuits between the metal electrode and the conductive substrate. In addition, because of this, it becomes difficult to connect a plurality of photovoltaic elements (subcells) through serial connection on a common conductive substrate.

Similarly, in the case of electrically connecting the upper electrode to the lower electrode by means of laser beam, short-circuits are often caused between the conductive substrate, the upper electrode and the lower electrode.

Thus, there are a number of problems required to be solved in the case of employing laser beam processing for the production of a solar cell using a conductive substrate.

As a means in order to avoid occurrence of the foregoing short-circuits with respect to the conductive substrate in the laser beam processing, there is considered a method in which the insulating layer is so thickened as to prevent laser beam from arriving at the conductive substrate. However, it is extremely difficult to form a thick film on a large area surface of flexible substrate in a uniform and flat state without causing film peeling. And it is not advisable to apply a thick film comprising a rigid inorganic material on the entire of said surface in view of flexibility required for a solar cell. Further in addition, in the case where the entire of said surface is coated by such thick film, there is also a problem that cracks are apt to occur and when those cracks occur, short-circuits are unavoidably caused between the metal electrode and the conductive substrate.

In view of the above, there is not a decisive means by which the foregoing problems in the prior art can be effectively solved. Those problems are left as being expected to be solved in the future.

Document JP-A-60 117 684 discloses a manufacturing method of an amorphous silicon solar cell, wherein in order to reduce damage to be generated in a masking process and to prevent short-circuits between the substrate and the electrodes, a mask with at least one of its layers coated with a polymer film is used.

Furthermore, document EP-A-0 103 168 discloses a solar cell according to the preamble of claim 1.

However, in connection with such a prior art arrangement, when adjacent photovoltaic elements are connected with each other by connecting the transparent upper electrode of one cell to the lower electrode of the adjacent cell by means of a laser beam, short-circuits are often caused between the conductive substrate, the upper electrode and the lower electrode. These short-circuits between the first electrode layer and the conductive substrate result in a low reliability of the solar cell manufactured in such a conventional fashion.

Hence, it is an object of the present invention to provide a solar cell, and a method of producing such a solar cell, which is free from the above mentioned drawbacks and thus highly reliable.

In particular, the object of the present invention is to eliminate the foregoing problems in known solar cells comprising a plurality of photovoltaic elements (subcells) on a conductive substrate and to provide a solar cell which satisfies the requirements with respect to weather resistance, shock resistance and flexibility, which provides a desired electromotive force and power capacity, which enables to optionally design the shape thereof and which can be mass-produced.

The present invention has been accomplished as a result of extensive by the present inventor in order to attain the above object.

According to the present invention, this object is achieved by a solar cell as defined in claim 1 and by a method of producing a solar cell as set out in claim 11. Advantageous further developments of the invention are defined in the dependent claims.

In the solar cell thus constituted according to the present invention, since the second insulating layer is disposed between the first insulating layer and the first electrode layer on the conductive substrate, excessive energy of the laser beam used in connecting a plurality of photovoltaic elements (subcells) to obtain a solar cell module is absorbed by said second insulating layer. Because of this, the first electrode layer is prevented from connecting to the conductive substrate while passing through the first insulating layer and as a result, the first electrode layer is prevented from being short-circuited with the conductive substrate.

And the solar cell of the present invention excels in weather resistance, shock resistance and flexibility, and stably provides a power supply over a long period of time even under severe use environment without causing short circuits since it is disposed on a conductive substrate such as metal or the like.

In the following, the present invention will be explained in more detail with reference to the drawings.
FIG. 1 shows a schematic diagram illustrating an example of the constitution of the solar cell according to the present invention.
FIG. 2 shows schematic diagrams illustrating the steps of producing the solar cell shown in FIG. 1 by integrating a plurality of photovoltaic elements.

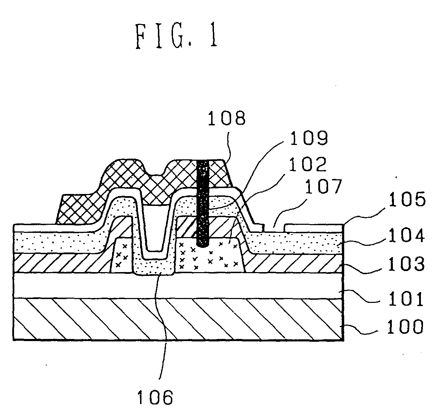

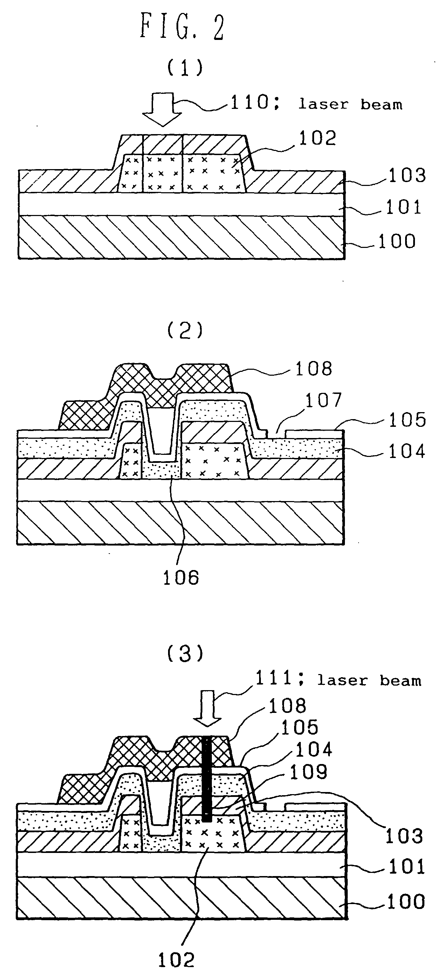

In FIGs. 1 and 2, reference numeral 100 is a conductive substrate, reference numeral 101 is a first insulating layer, reference numeral 102 is a second insulating layer, reference numeral 103 is a conductive electrode comprising a metal for example, reference numeral 104 is a semiconductor layer, reference numeral 105 is a transparent electrode, reference numeral 106 is a portion including the second insulating layer 102 and the conductive electrode 103 which is removed by irradiation of laser beam, reference numeral 107 is a portion of the transparent electrode 105 which is removed, reference numeral 108 is a collecting electrode, reference numeral 109 is an electrically connected portion among the conductive electrode 103, the semiconductor layer 104 and transparent electrode 105 which is formed by irradiation of laser beam, and each of reference numerals 110 and 111 stands for laser beam.

Explanation will be made of the process of producing the solar cell shown in FIG. 1 obtained by integrating a plurality of photovoltaic elements on a conductive substrate.

Firstly, a first insulating layer 101 is formed on a conductive substrate 100, then a second insulating layer 102 is formed thereon, and an electrode layer 103 is formed. (FIG. 2(1))

Part of the electrode layer 103 is removed by irradiating laser beam 110 to thereby divide the electrode layer 103. A semiconductor layer 104 is successively formed, and a transparent electrode layer 105 is formed. Thereafter, part of the transparent electrode layer 105 is removed to establish a dividing portion 107 by which a photovoltaic element is divided into a plurality of photovoltaic elements (subcells). A collecting electrode 108 is then formed. (FIG. 2(2))

In order to connect the adjacent photovoltaic elements (subcells) in series with each other, laser beam 111 is irradiated to connect the collecting electrode layer 108, transparent electrode layer 105 and the electrode layer 103. Thus, there is obtained a solar cell comprising a plurality of photovoltaic elements being integrated. (FIG. 2(3))

As the material of which the first insulating layer 101 is composed, there can be illustrated inorganic materials such as silicon oxide, silicon nitride, silicon carbide, alumina, etc. The first insulating layer is desired to be composed of such material that does not contain organic components liable to contaminate into and provide negative effects for any of the semiconductor layer and the electrode layer to be formed after the formation of the first insulating layer.

As the method of forming the first insulating layer, there can be illustrated a conventional film-forming method capable of forming a large area and uniform film such as a sputtering method, a CVD (chemical vapor deposition) method, etc.

The thickness of the first insulating layer is desired to be in the range of 300 nm (3000 Å) to 2 µm in consideration of the function to prevent occurrence of short circuits between the conductive substrate and the metal electrode, flexibility of the solar cell, productivity of the solar cell, and the like.

The material of which the second insulating layer is composed in the present invention is important to be such that is neither deformed nor deteriorated at the successive steps of forming the semiconductor layer and the transparent electrode layer. In addition, it is desired to have a heat resistant temperature of more than 150 °C.

As the material to satisfy these requirements, there can be illustrated resin materials of polyimide, polyphenylene sulfide, polyphenylene oxide, polyamideimide, polyester imide, polybenzimidazole, silicone, epoxy, etc., and sintering materials such as glass paste. These materials may be colored with the use of a colorant so that they effectively absorb the laser beam to be used upon producing the solar cell of the present invention. As such colorant in this case, there can be illustrated pigments such as amorphous carbon black, Al₂O₃, copper oxide, manganese dioxide, cobalt oxide, chromium oxide, α-Al₂O₃ type solid solution of (Cr,Fe)₂O₃, (Co,Ni)O(Cr,Fe)₂O₃ system spinel solid solution, spinel of CoO.nAl₂O₃, spinel of (Co,Zn)O.nAl₂O₃, 2(Co,Zn)O.SiO₂ uremite type solid solution, etc.

In the case of forming the second insulating layer, it is required to form said second insulating layer such that it is provided with a function to prevent occurrence of short circuits due to irradiation of the later beam used upon preparing the solar cell of the present invention. In view of this, it is desired for the second insulating layer to be formed at a thickness of 10 to 50 µm by an appropriate method capable of forming said second insulating layer precisely at a predetermined position. Specifically, as such method of forming the second insulating layer by using an inorganic material, there can be illustrated a method in which a solution of metal alcoholate, silanol compound or metal alkylate is applied and the resultant is subjected to heat treatment and a coating method in which a paste obtained by dispersing fine particles of the inorganic material used into a resin. Likewise, as for the case where a resin material is used, there can be illustrated a method in which a paste-like resin solution is applied in a predetermined pattern by means of a screen printer or a dispenser, the resultant is subjected to heat treatment and followed by drying.

As for the thickness of the second insulating layer, it is required to have such a thickness that excessive energy of the laser beam is effectively absorbed by the second insulating layer to thereby prevent the first insulating layer and the conductive substrate situated under the second insulating layer. Specifically, it is desired to be in the range of 10 to 50 µm.

The electrode layer may be properly formed by a resistance heating evaporation method, an electron beam evaporation method, a sputtering method, a CVD method or an impurity diffusion method.

In order to prepare the solar cell of the present invention by integrating a plurality of photovoltaic elements (subcells), an appropriate laser processing device is used. Representative examples of the light source of the laser processing device are Nd : YAG laser and excimer laser. The laser processing device using such laser light source is equipped with an oscillator, an optical unit and an autofocusing mechanism.

In the following, the present invention will be explained in more detail with reference to examples. However, the present invention is not restricted by these examples.

### Example 1

Explanation will be made of an example of the solar cell comprising a plurality of amorphous silicon photovoltaic elements integrated on a conductive substrate while referring to FIGs. 1 and 2.

FIG. 1 shows a schematic diagram illustrating an example of the solar cell according to the present invention. In this example, there were used a stainless steel film to be the conductive substrate 100, silicon nitride to be the first insulating layer 101, polyimide resin to be the second insulating layer 102, aluminum to be the electrode layer 103, pin junction amorphous silicon layer to be the semiconductor layer 104, In₂O₃-SnO₂ (ITO) to be the transparent electrode layer 105, and silver paste to be the collecting electrode. Further in this example, YAG laser was used for the laser processing.

In the following, the steps of preparing the foregoing solar cell will be explained with reference to FIG. 2.

Firstly, a 0.15 mm thick stainless substrate 100 having a ground surface as the conductive substrate was well cleaned. On the surface of said substrate was deposited a 2 µm thick silicon nitride film as the first insulating layer 101 by a plasma CVD method using SiH₄ gas and NH₃ gas. Then, polyimide resin was used to form the second insulating layer 102. Specifically, the formation of the second insulating layer 102 was performed as follows. That is, photosensitive resin was applied onto a metal mesh plate, and the resultant was subjected to pattern exposure and development. Insoluble portions were removed to obtain a printing plate. Then, using the resultant printing plate, polyimide PIX-3500 (trademark name) produced by Hitachi Chemical Co., Ltd. as polyimide resin was applied by means of screen printing in a predetermined patterned form, which was followed by heat treatment at 90 °C for an hour and at 350 °C for 30 minutes to thereby cure the polyimide resin, whereby a 15 µm thick second insulating layer was formed.

Thereafter, Al was evaporated by a sputtering method to form a 500 nm (5000 Å) thick Al layer as the electrode layer 103. YAG laser was irradiated to part of the Al electrode layer 103 (see, FIG. 2(1)) to divide the electrode layer 103 into plural parts. In this case, as the YAG laser, there was used Q-switching pulse laser with a frequency of 4 KHz, wherein the average laser power was made to be 0.4 W and the scanning speed was made to be 100 mm/sec.

The stainless substrate having the first insulating layer, the second insulating layer and the electrode layer 103 formed thereon was transferred to a capacitive-coupled type glow discharge film-forming apparatus, wherein a pin junction amorphous silicon semiconductor layer 104 was formed by glow discharge decomposition process under the conditions shown in Table 1.

**Table 1**

| semiconductor layer | raw material gas | flow rate (sccm) | pressure (Torr) Pascal | substrate temperature (°C) | high frequency power (W) | layer thickness (Å) nm |
|---|---|---|---|---|---|---|
| n-type | SiH₄ | 30 | (0.5) 66.6 | 250 | 50 | (200) 20 |
| a-Si layer | H₂ | 40 | | | | |
| | PH₃(H₂) | 10 | | | | |
| i-type | SiH₄ | 30 | (0.5) 66.6 | 250 | 50 | (3700) 370 |
| a-Si layer | H₂ | 40 | | | | |
| p-type | SiH₄ | 30 | (0.5) 66.6 | 250 | 50 | (100) 10 |
| a-Si layer | H₂ | 40 | | | | |
| | BF₃(H₂) | 10 | | | | |

Then, on the semiconductor layer 104 was formed a 80 nm (800 Å) thick ITO film as the transparent electrode layer by a resistance heating evaporation method.

Thereafter, part of the transparent electrode layer 105 was removed by screen-printing an etching agent comprising a paste-like material obtained by mixing FeCl₂, HCl, ethylene glycol and starch on the transparent electrode layer 105, to thereby form a dividing portion by which a cell is divided into a plurality of subcells. On the transparent electrode layer 105 was applied a silver paste (trademark name : No. 5007, produced by Du Pont Company) at a thickness of 20 µm by screen printing, to thereby form the collecting electrode 108. (see, FIG. 2(2)).

In order to connect the photovoltaic elements (subcells) in series, YAG laser was irradiated over the collecting electrode 108 to thereby fuse the collecting electrode 108, the transparent electrode layer (comprising ITO) 105, the semiconductor layer 104 and the metal electrode layer 103 to establish an electrical connection among the collecting electrode 108, the transparent electrode layer (comprising ITO) 105 and the metal electrode layer 103, whereby an amorphous silicon solar cell comprising a plurality of photovoltaic elements (subcells) being integrated. In this case, as the YAG laser, there was used the same as that used in dividing the metal electrode layer 103, wherein the average laser power was made to be 0.9 W. In this example, the collecting electrode was formed. But this can be omitted in the case where the width of each of the subcells is narrow, that is, the width of the transparent electrode layer is narrow and the resistance value of the transparent electrode layer can be disregarded.

Further, in this example, the pin junction semiconductor layer 104 was constituted by an amorphous silicon single layer, but it can be of a multi-layered structure comprising, for example, pin/pin, pin/pin/pin, or the like, wherein amorphous silicon carbide or amorphous silicon germanium can be used.

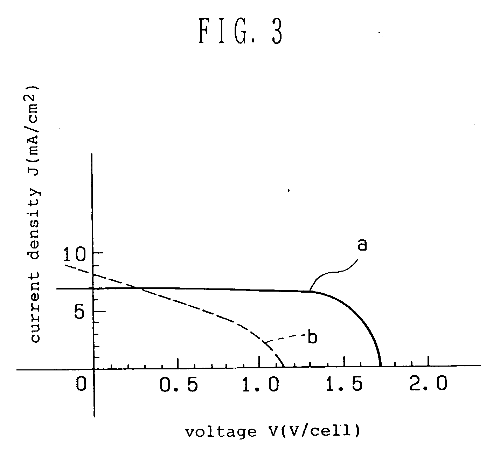

For the resultant solar cell comprising two pin junction photovoltaic elements (subcells) being integrated in series, its current-voltage (I-V) characteristics under irradiation of AM-1 light (100 mW/cm²) were observed. The results obtained were collectively shown by line a in FIG. 3. From the I-V characteristics, it is understood that the open circuit voltage (Voc) is 1.7 V. This indicates the Voc which is provided in the case where two subcells are integrated in series. Thus, it is understood that no short circuit was occurred at the time of having integrated those subcells.

In addition, the solar cell obtained in this example was evaluated using a solar simulator having spectra approximate to AM-1 light. As a result, it exhibited an excellent photoelectric conversion efficiency of 8.2%.

### Example 2

The procedures of Example 1 were repeated, except that silicone resin was used in the formation of the second insulating layer 102, to thereby obtain a solar cell of the same constitution as that in Example 1.

Particularly, the formation of the second insulating layer was performed by applying a heat resistant silicone resin (trademark name : TSE 326, produced by Toshiba Silicone Company) at a thickness of 30 µm by an ink dispenser, followed by heat treatment at 150 °C for an hour.

As for the resultant solar cell comprising two photovoltaic elements (subcells) being integrated in series as in Example 1, its current-voltage characteristics were observed in the same manner as in Example 1. As a result, it is understood that the solar cell is free of short circuit also in this example.

It was found that the solar cell obtained using the silicone resin for the formation of its second insulating layer in this example excels in bending strength and has a high reliability.

### Example 3

The procedures of Example 1 were repeated, except that silicon oxide was formed using silanol compound as the starting material in the formation of the second insulating layer 102, to thereby obtain a solar cell of the same constitution as that in Example 1.

Particularly, the formation of the second insulating layer was performed as follows. That is, a material obtained by admixing 3 % by weight of (Co,Ni)O(Cr,Fe)₂O₃ spinel solid solution with silanol compound (trademark name : OCD type-785R, produced by Tokyo Ohka Kabushiki Kaisha) was applied by an ink dispenser, followed by heat treatment at 150 °C for 30 minutes, at 300 °C for 30 minutes and at 420 °C for 30 minutes, to thereby form a 10 µm thick silicon oxide film.

As for the resultant solar cell comprising two photovoltaic elements (subcells) being integrated in series as in Example 1, its current-voltage characteristics were observed in the same manner as in Example 1. As a result, it is understood that the solar cell is free of short circuit also in this example.

Further, in this example, since the second insulating layer was constituted by the silicon oxide obtained from the silanol compound, the amount of gas released in the step of forming the amorphous silicon film was slight and because of this, the resultant amorphous silicon film was of a high quality. And the resultant solar cell exhibited an improved photoelectric conversion efficiency.

### Example 4

The procedures of Example 1 were repeated, except that the second insulating layer 102 was formed using epoxy resin in which glass beads being dispersed, to thereby obtain a solar cell of the same constitution as that in Example 1.

Particularly, the formation of the second insulating layer was performed as follows. That is, a paste obtained by admixing 5% by weight of glass beads of 7 µm in diameter with epoxy compounded resin (trademark name : 2068 K, produced by Three Bond Company) was screen-printed at a thickness of 15 µm, followed by heat treatment at 150 °C for 30 minutes, to thereby form an insulating film.

As for the resultant solar cell comprising two photovoltaic elements (subcells) being integrated in series as in Example 1, its current-voltage characteristics were observed in the same manner as in Example 1. As a result, it is understood that the solar cell is free of short circuit also in this example.

Further, in this example, the second insulating layer was formed using the epoxy resin in which glass beads being dispersed. Because of this, the solar cell comprising a plurality of photovoltaic elements being formed on a conductive substrate can be provided at a reduced production cost.

### Example 5

There was used a 0.2 mm thick aluminum foil as the conductive substrate 100. On this substrate was firstly formed a silicon oxide film to be the first insulating layer 101 by a plasma CVD method using tetraethoxysilane and O₂ gas.

Successively, a glass paste PLS-2401 (trademark name, produced by Nippon Denki Glass Company, composition : PbO-B₂O₃-SiO₂) was applied onto the first insulating layer 101 in a predetermined patterned form by screen printing, followed by drying at 150 °C for 10 minutes and subjecting to sintering at 550 °C for 10 minutes, to thereby form a second insulating layer 102.

Then, a 500 nm (5000 Å) thick Mo film to be the metal electrode 103 was formed by an electron beam evaporation method. YAG laser 110 was irradiated to part of the metal electrode under which the second insulating layer 102 being situated to divide the metal electrode 103 into plural parts. (see, FIG. 2(1)).

There were successively formed a 200 nm (2000 Å) thick Cu layer and a 400 nm (4000 Å) thick In layer respectively by an electron beam evaporation method. The resultant was treated in H₂Se vapor, followed by heat treatment at 400 °C in nitrogen atmosphere. Thereafter, there was deposited a 50 nm (500 Å) thick CdS layer by a sputtering method. Thus, there was formed a semiconductor layer 104. A 70 nm (700 Å) thick ZnO film to be the transparent electrode layer 105 was then formed by a sputtering method. The remaining steps followed Example 1. Thus, there was obtained a copper indium selenide solar cell comprising a plurality of photovoltaic elements (subcells) being integrated.

As for the resultant solar cell comprising two photovoltaic elements (subcells) being integrated in series, its current-voltage characteristics were observed in the same manner as in Example 1. As a result, the value of the open circuit voltage (Voc) was 1.0 V. This indicates the Voc which is provided in the case where two subcells are integrated in series. Thus, it is understood that no short circuit was occurred at the time of having integrated those subcells.

It should be understood that the present invention is not restricted by the above example. For instance, the semiconductor layer 104 shown in FIG. 1 may be comprised of any of other compound semiconductors or pn junction polycrystal silicon semiconductors than the CuInSe₂/CdS. In the case of using said pn junction polycrystal silicon semiconductor, a layer doped with an impurity in a high concentration can serves also as the transparent electrode, it is possible to omit the transparent electrode 105.

### Comparative Example 1

The procedures of Example 1 were repeated, except that no second insulating layer was formed, to thereby obtain an amorphous silicon solar cell.

For the resultant solar cell comprising two pin junction photovoltaic elements (subcells) being integrated in series, its current-voltage (I-V) characteristics under irradiation of AM-1 light (100 mW/cm²) were observed. The results obtained were collectively shown by line b in FIG. 3. From the I-V characteristics, it is understood that the open circuit voltage (Voc) of the solar cell obtained in this comparative example is markedly inferior to the value 1.7 V which was expected to provide in the case of integrating two solar cell elements in series. Thus, it is understood that short circuits were occurred at the time of having integrated those elements.

In addition, the solar cell obtained in this comparative example was evaluated using the same solar simulator as used in Example 1. As a result, it exhibited a photoelectric conversion efficiency of 3.3% which is markedly inferior to that obtained in Example 1.

### Comparative Example 2

The procedures of Example 5 were repeated, except that no second insulating layer was formed, to thereby obtain a copper indium selenide solar cell.

For the resultant solar cell comprising two photovoltaic elements (subcells) being integrated in series, its current-voltage (I-V) characteristics were observed in the same manner as in Example 1. From the I-V characteristics, it was found that the open circuit voltage (Voc) of the solar cell obtained in this comparative example is 0.5 V. Thus, it is understood that this open circuit voltage (Voc) is markedly inferior to that obtained in the case where no short circuit exists. And it is understood that short circuits were occurred at the time of having integrated those elements.

As apparent from the results in the foregoing examples and comparative examples, it is understood that in the solar cell according to the present invention which is provided with the second insulating layer between the first insulating layer and the metal electrode layer, since excessive energy of the laser beam used upon preparing the solar cell is effectively absorbed by the second insulating layer, a plurality of photovoltaic elements can be desirably integrated on a common conductive substrate without occurrence of short circuits between the metal electrode layer and the conductive substrate.

Because of this, the solar cell according to the present invention can be so designed as to be capable of providing a desired electromotive force and a desired power capacity.

In addition, since the solar cell according to the present invention is provided with the first insulating layer composed of a selected specific material and the second insulating layer also composed of a selected specific material, it excels in weather resistance, shock resistance and flexibility, and it stably provides a power supply over a long period of time even under severe use environment.
FIG. 1 shows a schematic diagram of an example of the solar cell according to the present invention.
FIG. 2 shows schematic diagrams illustrating typical steps of preparing the solar cell according to the present invention.
FIG. 3 shows graphs illustrating the I-V characteristics obtained under light irradiation with respect to each of the solar cells respectively comprising two photovoltaic elements being integrated in series obtained in Example 1 and Comparative Example 1.
FIGs. 4 and 5 are schematic diagrams respectively of the known solar cell in which a conductive substrate is used.

## Claims

1. A solar cell comprising a plurality of photovoltaic elements serially electrically connected with each other on a common conductive substrate (100),
each of said photovoltaic elements comprising a first insulating layer (101), a conductive electrode layer (103), a semiconductor layer (104), and a transparent electrode layer (105) laminated in this order on said common conductive substrate (100), and
each pair of adjacent photovoltaic elements being serially electrically connected, by electrically connecting said conductive electrode layer (103) of one adjacent photovoltaic element to said transparent electrode layer (105) of the other adjacent photovoltaic element,
**characterized in that**
a second insulating layer (102) having a heat resistant temperature of more than 150°C and a thickness of 10 to 50 µm is disposed in a predetermined patterned form on said first insulating layer (101) and underneath said conductive electrode layer (103), said conductive electrode layer (103) and said second insulating layer (102) being divided into two portions by removing a part (106) of them; the removed part (106) between the two portions is filled with the corresponding parts of said semiconductor layer (104) and said transparent electrode layer (105); an electrically connected portion (109) among the conductive electrode layer (103), the semiconductor layer (104) and the transparent electrode layer (105) ensures the serial electrical connection between adjacent photovoltaic elements, and
said second insulating layer (102) is disposed in a region corresponding to the electrically connected portion (109).

2. A solar cell according to claim 1, **characterized in that** said first insulating layer (101) is of a thickness of 300 nm to 2 µm.

3. A solar cell according to claim 1, **characterized in that** said first insulating layer (101) is composed of an inorganic material.

4. A solar cell according to claim 1, **characterized in that** said second insulating layer (102) is composed of a resin.

5. A solar cell according to claim 4, **characterized in that** said second insulating layer (102) is composed of polyimide resin.

6. A solar cell according to claim 4, **characterized in that** said second insulating layer (102) is composed of silicone resin.

7. A solar cell according to claim 1, **characterized in that** said second insulating layer (102) is composed of silicone oxide obtained from a silanol compound.

8. A solar cell according to claim 1, **characterized in that** said second insulating layer (102) is composed of an epoxy resin in which glass beads are dispersed.

9. A solar cell according to claim 1, **characterized in that** said second insulating layer (102) is composed of a glass obtained from a glass paste.

10. A solar cell according to claim 1, **characterized in that** said second insulating layer (102) contains an inorganic pigment, amorphous carbon black, or alumina which is capable of absorbing a laser beam.

11. A method of producing a solar cell comprising a plurality of photovoltaic elements serially electrically connected with each other on a common conductive substrate (100), comprising the steps of:
forming a first insulating layer (101), a second insulating layer (102) in a predetermined patterned form, and a conductive electrode layer (103) in this order on said conductive substrate (100), said second insulating layer (102) having heat resistant temperature of more than 150°C and a thickness of 10 to 50 µm;
removing a portion (106) of said second insulating layer (102) and said conductive electrode layer (103) by laser beam irradiation;
forming a semiconductor layer (104) and a transparent electrode layer (105) on the conductive electrode layer (103) and in the removed portion (106);
removing a portion (107) of said transparent electrode layer (105) to form said plurality of photovoltaic elements; and
serially electrically connecting each pair of adjacent photovoltaic elements by electrically connecting by laser beam irradiation said conductive electrode layer (103) of one adjacent photovoltaic element to said transparent electrode layer (105) of the other adjacent photovoltaic element through the semiconductor layer (104) in a region (109) corresponding to the part of the second insulating layer (102) left after removal.

12. A solar cell according to claim 1, **characterized by** further comprising a collecting electrode (108) being disposed on said transparent electrode layer (105) in a region corresponding to the removed part (106) and the two portions of said conductive electrode layer (103) and said second insulating layer (102).

## Patentansprüche

1. Solarzelle, die eine Vielzahl photovoltaischer Elemente umfasst, die auf einem gemeinsamen leitfähigen Substrat (100) seriell elektrisch miteinander verbunden sind, wobei
jedes der photovoltaischen Elemente eine erste Isolierschicht (101), eine leitfähige Elektrodenschicht (103), eine Halbleiterschicht (104) und eine transparente Elektrodenschicht (105) umfasst, die in dieser Reihenfolge auf dem gemeinsamen leitfähigen Substrat (100) laminiert sind, und
jedes Paar benachbarter photovoltaischer Elemente durch ein elektrisches Verbinden der leitfähigen Elektrodenschicht (103) eines benachbarten photovoltaischen Elements mit der transparenten Elektrodenschicht (105) des anderen benachbarten photovoltaischen Elements seriell elektrisch miteinander verbunden ist,
**dadurch gekennzeichnet, dass**
eine zweite Isolierschicht (102) mit einer Hitzebeständigkeitstemperatur von mehr als 150 °C und einer Dicke von 10 bis 50 µm in einer vorbestimmten, gemusterten Form auf der ersten Isolierschicht (101) und unterhalb der leitfähigen Elektrodenschicht (103) angeordnet ist, wobei die leitfähige Elektrodenschicht (103) und die zweite Isolierschicht (102) durch das Entfernen eines Teils (106) von diesen in zwei Bereiche unterteilt sind; der entfernte Teil (106) zwischen den zwei Bereichen mit den entsprechenden Teilen der Halbleiterschicht (104) und der transparenten Elektrodenschicht (105) aufgefüllt ist; ein elektrisch verbundener Bereich (109) unter der leitfähigen Elektrodenschicht (103), der Halbleiterschicht (104) und der transparenten Elektrodenschicht (105) die serielle elektrische Verbindung zwischen benachbarten photovoltaischen Elementen sicherstellt, und
die zweite Isolierschicht (102) in einer dem elektrisch verbundenen Bereich (109) entsprechenden Region angeordnet ist.

2. Solarzelle nach Anspruch 1,
**dadurch gekennzeichnet, dass**
die erste Isolierschicht (101) eine Dicke von 300 nm bis 2 µm aufweist.

3. Solarzelle nach Anspruch 1,
**dadurch gekennzeichnet, dass**
die erste Isolierschicht (101) aus einem anorganischen Material zusammengesetzt ist.

4. Solarzelle nach Anspruch 1,
**dadurch gekennzeichnet, dass**
die zweite Isolierschicht (102) aus einem Harz zusammengesetzt ist.

5. Solarzelle nach Anspruch 4,
**dadurch gekennzeichnet, dass**
die zweite Isolierschicht (102) aus einem Polyimidharz zusammengesetzt ist.

6. Solarzelle nach Anspruch 4,
**dadurch gekennzeichnet, dass**
die zweite Isolierschicht (102) aus einem Siliconharz zusammengesetzt ist.

7. Solarzelle nach Anspruch 1,
**dadurch gekennzeichnet, dass**
die zweite Isolierschicht (102) aus Siliciumoxid, das aus einer Silanolverbindung erhalten wird, zusammengesetzt ist.

8. Solarzelle nach Anspruch 1,
**dadurch gekennzeichnet, dass**
die zweite Isolierschicht (102) aus einem Epoxidharz, in das Glaskügelchen dispergiert sind, zusammengesetzt ist.

9. Solarzelle nach Anspruch 1,
**dadurch gekennzeichnet, dass**
die zweite Isolierschicht (102) aus einem Glas, das aus einer Glaspaste erhalten wird, zusammengesetzt ist.

10. Solarzelle nach Anspruch 1,
**dadurch gekennzeichnet, dass**
die zweite Isolierschicht (102) ein anorganisches Pigment, amorphen Ruß oder Aluminiumoxid, die einen Laserstrahl absorbieren können, enthält.

11. Verfahren zur Herstellung einer Solarzelle, die eine Vielzahl photovoltaischer Elemente umfasst, die auf einem gemeinsamen leitfähigen Substrat (100) seriell elektrisch miteinander verbunden sind, welches die folgenden Schritte umfasst:
Bilden einer ersten Isolierschicht (101), einer zweiten Isolierschicht (102) in einer vorbestimmten, gemusterten Form und einer leitfähigen Elektrodenschicht (103) in dieser Reihenfolge auf dem leitfähigen Substrat (100), wobei die zweite Isolierschicht (102) eine Hitzebeständigkeitstemperatur von mehr als 150 °C und eine Dicke von 10 bis 50 µm aufweist;
Entfernen eines Bereichs (106) der zweiten Isolierschicht (102) und der leitfähigen Elektrodenschicht (103) durch Bestrahlung mit einem Laserstrahl;
Bilden einer Halbleiterschicht (104) und einer transparenten Elektrodenschicht (105) auf der leitfähigen Elektrodenschicht (103) und in dem entfernten Bereich (106);
Entfernen eines Bereichs (107) der transparenten Elektrodenschicht (105), um die Vielzahl photovoltaischer Elemente zu bilden; und
serielles elektrisches Verbinden eines jeden Paares benachbarter photovoltaischer Elemente durch das elektrische Verbinden mittels Bestrahlung mit einem Laserstrahl der leitfähigen Elektrodenschicht (103) des einen benachbarten photovoltaischen Elements mit der transparenten Elektrodenschicht (105) des anderen benachbarten photovoltaischen Elements durch die Halbleiterschicht (104) hindurch in einer Region (109), die dem Teil der nach dem Entfernen verbleibenden zweiten Isolierschicht (102) entspricht.

12. Solarzelle nach Anspruch 1,
**dadurch gekennzeichnet, dass**
sie zusätzlich eine Sammelelektrode (108) umfasst, die auf der transparenten Elektrodenschicht (105) in einer Region angeordnet ist, die dem entfernten Teil (106) und den beiden Bereichen der leitfähigen Elektrodenschicht (103) und der zweiten Isolierschicht (102) entspricht.

## Revendications

1. Pile solaire comportant plusieurs éléments photovoltaïques connectés électriquement en série les uns aux autres sur un substrat conducteur commun (100), chacun desdits éléments photovoltaïques comportant une première couche isolante (101), une couche d'électrode conductrice (103), une couche de semiconducteur (104) et une couche d'électrode transparente (105) stratifiées dans cet ordre sur ledit substrat conducteur commun (100), et
chaque paire d'éléments photovoltaïques adjacents étant connectée électriquement en série, par une connexion électrique de ladite couche d'électrode conductrice (103) d'un élément photovoltaïque adjacent à ladite couche d'électrode transparente (105) de l'autre élément photovoltaïque adjacent,
caractérisée en ce que
une seconde couche isolante (102) ayant une température de résistance à la chaleur de plus de 150°C et une épaisseur de 10 à 50 µm est disposée dans une forme d'un motif prédéterminé sur ladite première couche isolante (101) et au-dessous de ladite couche d'électrode conductrice (103), ladite couche d'électrode conductrice (103) et ladite seconde couche isolante (102) étant disposées en deux portions par l'enlèvement d'une partie (106) de ces couches ; la partie enlevée (106) entre les deux portions est remplie par les parties correspondantes de ladite couche de semiconducteur (104) et de ladite couche d'électrode transparente (105) ; une portion (109) connectée électriquement entre la couche d'électrode conductrice (103), la couche de semiconducteur (104) et la couche d'électrode transparente (105) assure la connexion électrique en série entre des éléments photovoltaïques adjacents, et
ladite seconde couche isolante (102) est disposée dans une région correspondant à la portion connectée électriquement (109).

2. Pile solaire selon la revendication 1, caractérisée en ce que ladite première couche isolante (101) est d'une épaisseur de 300 nanomètres à 2 µm.

3. Pile solaire selon la revendication 1, caractérisée en ce que ladite première couche isolante (101) est composée d'une matière inorganique.

4. Pile solaire selon la revendication 1, caractérisée en ce que ladite seconde couche isolante (102) est composée d'une résine.

5. Pile solaire selon la revendication 4, caractérisée en ce que ladite seconde couche isolante (102) est composée d'une résine du type polyimide.

6. Pile solaire selon la revendication 4, caractérisée en ce que ladite seconde couche isolante (102) est composée d'une résine de silicone.

7. Pile solaire selon la revendication 1, caractérisée en ce que ladite seconde couche isolante (102) est composée d'oxyde de silicone obtenu à partir d'un composé de silanol.

8. Pile solaire selon la revendication 1, caractérisée en ce que ladite seconde couche isolante (102) est composée d'une résine époxy dans laquelle des billes de verre sont dispersées.

9. Pile solaire selon la revendication 1, caractérisée en ce que ladite seconde couche isolante (102) est composée d'un verre obtenu à partir d'une pâte de verre.

10. Pile solaire selon la revendication 1, caractérisée en ce que ladite seconde couche isolante (102) contient un pigment inorganique, du noir de carbone amorphe ou de l'alumine qui est capable d'absorber un faisceau laser.

11. Procédé de production d'une pile solaire comportant plusieurs éléments photovoltaïques connectés électriquement en série les uns aux autres sur un substrat conducteur commun (100), comprenant les étapes dans lesquelles :
on forme une première couche isolante (101), une seconde couche isolante (102) dans une forme d'un motif prédéterminé, et une couche d'électrode conductrice (103), dans cet ordre, sur ledit substrat conducteur (100), ladite seconde couche isolante (102) ayant une température de résistance à la chaleur de plus de 150°C et une épaisseur de 10 à 50 µm ;
on enlève une portion (106) de ladite seconde couche isolante (102) et de ladite couche d'électrode conductrice (103) par irradiation par un faisceau laser ;
on forme une couche de semiconducteur (104) et une couche d'électrode transparente (105) sur la couche d'électrode conductrice (103) et dans la portion enlevée (106) ;
on enlève une portion (107) de ladite couche d'électrode transparente (105) pour former ladite pluralité d'éléments photovoltaïques ; et
on connecte électriquement en série chaque paire d'éléments photovoltaïques adjacents en connectant électriquement par irradiation par un faisceau laser ladite couche d'électrode conductrice (103) d'un élément photovoltaïque adjacent à ladite couche d'électrode transparente (105) de l'autre élément photovoltaïque adjacent à travers la couche de semiconducteur (104) dans une région (109) correspondant à la partie de la seconde couche isolante (102) qui reste après l'enlèvement.

12. Pile solaire selon la revendication 1, caractérisée en ce qu'elle comporte en outre une électrode collectrice (108) disposée sur ladite couche d'électrode transparente (105) dans une région correspondant à la partie enlevée (106) et aux deux portions de ladite couche d'électrode conductrice (103) et de ladite seconde couche isolante (102).
